# EUROPÄISCHE PATENTSCHRIFT

(11) **EP 1 668 718 B1**
(45) Veröffentlichungstag und Bekanntmachung des Hinweises auf die Patenterteilung: **25.03.2009**
(21) Anmeldenummer: 04765279.7
(22) Anmeldetag: 16.09.2004
(51) Int. Cl.: H01L 51/30

(54) **ORGANISCHES ELEKTROLUMINESZENZELEMENT**
ORGANIC ELECTROLUMINESCENT ELEMENT
ELEMENT ELECTROLUMINESCENT ORGANIQUE

(30) Priorität: 19.09.2003 DE 10343910; 25.11.2003 DE 10355381
(43) Veröffentlichungstag der Anmeldung: 14.06.2006
(73) Patentinhaber: Merck Patent GmbH, 64293 Darmstadt (DE)
(72) Erfinder: VESTWEBER, Horst, 34830 Gilserberg-Winterscheid (DE); GERHARD, Anja, 64291 Darmstadt (DE); STÖSSEL, Philipp, 60487 Frankfurt am Main (DE)
(86) Internationale Anmeldenummer: PCT/EP2004/010379
(87) Internationale Veröffentlichungsnummer: WO 2005/034260

(56) Entgegenhaltungen:
- EP-A- 1 286 569
- EP-A- 1 308 494
- WO-A-20/04016709
- ADACHI C ET AL: "EFFICIENT ELECTROPHOSPHORESCENCE USING A DOPED AMBIPOLAR CONDUCTIVE MOLECULAR ORGANIC THIN FILM" ORGANIC ELECTRONICS, ELSEVIER, AMSTERDAM, NL, Bd. 2, Nr. 1, März 2001 (2001-03), Seiten 37-43, XP001100539 ISSN: 1566-1199 in der Anmeldung erwähnt
- BALDO M A ET AL: "HIGHLY EFFICIENT PHOSPHORESCENT EMISSION FROM ORGANIC ELECTROLUMINESCENT DEVICES" NATURE, MACMILLAN JOURNALS LTD. LONDON, GB, Bd. 395, Nr. 6698, 10. September 1998 (1998-09-10), Seiten 151-154, XP001002103 ISSN: 0028-0836
- SALBECK J ET AL: "Low molecular organic glasses for blue electroluminescence" SYNTHETIC METALS, ELSEVIER SEQUOIA, LAUSANNE, CH, Bd. 91, 1997, Seiten 209-215, XP002277588 ISSN: 0379-6779
- WU C C ET AL: "Highly bright blue organic light-emitting devices using spirobifluorene-cored conjugated compounds" APPLIED PHYSICS LETTERS, AMERICAN INSTITUTE OF PHYSICS. NEW YORK, US, Bd. 81, Nr. 4, 22. Juli 2002 (2002-07-22), Seiten 577-579, XP012033022 ISSN: 0003-6951
- SCOTT J C; CARTER S A; KARG S; ANGELOPOULOS M: "Polymeric anodes for organic light-emitting diodes" SYNTHETIC MATERIALS, Bd. 85, 15. Februar 1997 (1997-02-15), Seiten 1197-1200,

## Beschreibung

Die vorliegende Erfindung beschreibt ein neuartiges Designprinzip für organische Elektrolumineszenzelemente und dessen Verwendung in darauf basierenden Displays.

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden schon seit etlichen Jahren lichtsensitive organische Materialien (z. B. Phthalocyanine) sowie organische Ladungstransportmaterialien (i. d. R. Lochtransporter auf Triarylaminbasis) Verwendung in Kopiergeräten. Der Einsatz halbleitender organischer Verbindungen, die zum Teil auch zur Emission von Licht im sichtbaren Spektralbereich befähigt sind, steht gerade am Anfang der Markteinführung, zum Beispiel in organischen Elektrolumineszenzvorrichtungen. Deren Einzelbauteile, die organischen lichtemittierenden Dioden (OLEDs), besitzen ein sehr breites Anwendungsspektrum als:
1. weiße oder farbige Hinterleuchtungen für monochrome oder mehrfarbige Anzeigeelemente (z. B. im Taschenrechner, für Mobiltelefone, etc.),
2. großflächige Anzeigen (z. B. Verkehrsschilder, Plakate, etc.),
3. Beleuchtungselemente in allen Farben und Formen,
4. monochrome oder vollfarbige Passiv-Matrix-Displays für tragbare Anwendungen (z. B. Mobiltelefone, PDAs, Camcorder, etc.),
5. vollfarbige, großflächige, hochaufgelöste Aktiv-Matrix-Displays für verschiedenste Anwendungen (z. B. Mobiltelefone, PDAs, Laptops, Fernseher, etc.).

Bei diesen Anwendungen ist die Entwicklung teilweise bereits weit fortgeschritten; dennoch besteht immer noch großer Bedarf an technischen Verbesserungen.

Für einfachere OLEDs enthaltende Vorrichtungen ist die Markteinführung bereits erfolgt, wie die Autoradios der Firma Pioneer, die Mobiltelefone der Firmen Pioneer und SNMD oder eine Digitalkamera der Firma Kodak mit "Organischem Display" belegen. Allerdings gibt es immer noch erhebliche Probleme, die einer dringenden Verbesserung bedürfen:
1. So ist v. a. die operative Lebensdauer von OLEDs immer noch gering, so daß bis dato nur einfache Anwendungen kommerziell realisiert werden können.
2. Diese relativ kurze Lebensdauer ergibt noch ein Folgeproblem: Gerade für Vollfarb-Anwendungen ("full-color-displays"), d. h. Displays, welche keine Segmentierungen aufweisen, sondern über die ganze Fläche alle Farben darstellen können, ist es besonders schlecht, wenn hier die einzelnen Farben unterschiedlich schnell altern, wie dies derzeit der Fall ist. Dies führt dazu, daß es schon vor Ende der Lebensdauer (die in der Regel durch einen Abfall auf 50 % der Anfangshelligkeit definiert ist) zu einer deutlichen Verschiebung des Weiß-Punkts kommt, d. h. die Farbtreue der Darstellung im Display sehr schlecht wird. Um dies zu umgehen, definieren einige Displayhersteller die Lebensdauer als 70 % oder 90 %-Lebensdauer (d. h. Abfall der Anfangshelligkeit auf 70 % bzw. auf 90 % des Anfangswertes). Dies führt aber dazu, daß die Lebensdauer noch kürzer wird.
3. Die Effizienzen, insbesondere die Leistungseffizienz (gemessen in Im/W), von OLEDs sind zwar akzeptabel, aber auch hier sind immer noch Verbesserungen erwünscht.
4. Die Alterungsprozesse gehen i. d. R. mit einem Anstieg der Spannung einher. Dieser Effekt macht spannungsgetriebene organische Elektrolumineszenzvorrichtungen schwierig bzw. unmöglich. Eine stromgetriebene Ansteuerung ist aber gerade in diesem Fall aufwendiger und teurer.
5. Die benötigte Betriebsspannung ist gerade bei effizienten phosphoreszierenden OLEDs recht hoch und muß daher weiter verringert werden, um die Leistungseffizienz zu verbessern. Das ist gerade für tragbare Anwendungen ("portable applications") von großer Bedeutung.
6. Der benötigte Betriebsstrom ist ebenfalls in den letzten Jahren verringert worden, muß aber noch weiter verringert werden, um die Leistungseffizienz zu verbessern.
7. Der Aufbau der OLEDs ist durch die Vielzahl der organischen Schichten komplex und teuer; eine Reduktion der Schichtenanzahl ist für die Produktion sehr wichtig, um die Produktionsschritte zu verringern und damit die Kosten zu senken und die Produktionssicherheit zu erhöhen.

Die oben genannten Probleme machen Verbesserungen bei der Herstellung von OLEDs notwendig. Eine Entwicklung hierzu, die sich in den letzten Jahren abzeichnet, ist der Einsatz metallorganischer Komplexe, die Phosphoreszenz statt Fluoreszenz zeigen [M. A. Baldo, S. Lamansky, P. E. Burrows, M. E. Thompson, S. R. Forrest, Appl. Phys. Lett. 1999, 75, 4-6]. Aus quantenmechanischen Gründen ist unter Verwendung metallorganischer Verbindungen eine bis zu vierfache Quanten-, Energie- und Leistungseffizienz möglich. Ob sich diese neue Entwicklung durchsetzen wird, hängt stark davon ab, ob entsprechende Device-Kompositionen gefunden werden können, die diese Vorteile (Triplett-Emission = Phosphoreszenz gegenüber Singulett-Emission = Fluoreszenz) auch in OLEDs umsetzen können. Als wesentliche Bedingungen für die praktische Anwendung sind hier insbesondere eine hohe operative Lebensdauer, eine hohe Stabilität gegenüber Temperaturbelastung und eine niedrige Einsatz- und Betriebsspannung verbunden mit einer hohen Leistungseffizienz, um mobile Applikationen zu ermöglichen, zu nennen.

Der allgemeine Aufbau fluoreszierender organischer Elektrolumineszenzvorrichtungen ist beispielsweise in US 4,539,507 und US 5,151,629 beschrieben. Üblicherweise besteht eine organische Elektrolumineszenzvorrichtung aus mehreren Schichten, die mittels Vakuummethoden oder unterschiedlicher Drucktechniken aufeinander aufgebracht werden. Für phosphoreszierende organische Elektrolumineszenzvorrichtungen sind diese Schichten im einzelnen:
1. Eine Trägerplatte = Substrat (üblicherweise Glas oder Kunststoffolie).
2. Eine transparente Anode (üblicherweise Indium-Zinn-Oxid, ITO).
3. Eine Lochinjektions-Schicht (**H**ole **I**njection **L**ayer = HIL): z. B. auf der Basis von Kupferphthalocyanin (CuPc) oder leitfähigen Polymeren, wie Polyanilin (PANI) oder Polythiophen-Derivaten (wie PEDOT).
4. Eine oder mehrere Lochtransport-Schichten (**H**ole **T**ransport **L**ayer = HTL): üblicherweise auf der Basis von Triarylamin-Derivaten, z. B. 4,4`,4"-Tris(N-1-naphthyl-N-phenyl-amino)-triphenylamin (NaphDATA) als erste Schicht und N,N'-Di(naphth-1-yl)-N,N'-diphenyl-benzidin (NPB) als zweite Lochtransportschicht.
5. Eine oder mehrere Emissions-Schichten (**Em**ission **L**ayer = EML): üblicherweise aus mit Phosphoreszenzfarbstoffen, z. B. Tris-(phenylpyridyl)-iridium (Ir(PPy)₃) oder Tris-(2-benzothiophenyl-pyridyl)-iridium (Ir(BTP)₃), dotierten Matrixmaterialien, wie z. B. 4,4'-Bis(carbazol-9-yl)-biphenyl (CBP); die Emissions-Schicht kann aber auch aus Polymeren, Mischungen von Polymeren, Mischungen von Polymeren und niedermolekularen Verbindungen oder Mischungen verschiedener niedermolekularer Verbindungen bestehen.
6. Eine Lochblockier-Schicht (**H**ole-**B**locking-**L**ayer = HBL): üblicherweise aus BCP (2,9-Dimethyl-4,7-diphenyl-1,10-phenanthrolin = Bathocuproin) oder Bis-(2-methyl-8-chinolinolato)-(4-phenylphenolato)-aluminium(III) (BAlq).
7. Eine Elektronentransport-Schicht (**E**lectron **T**ransport **L**ayer = ETL): meist auf Basis von Aluminium-tris-8-hydroxychinolinat (AlQ₃).
8. Eine Elektroneninjektions-Schicht (**E**lectron **I**njection **L**ayer = EIL) (auch teilweise Isolatorschicht (ISL) genannt): ein dünne Schicht bestehend aus einem Material mit einer hohen Dielektrizitätskonstanten, wie z. B. LiF, Li₂O, BaF₂, MgO, NaF.
9. Eine Kathode: hier werden in der Regel Metalle, Metallkombinationen oder Metallegierungen mit niedriger Austrittsarbeit verwendet, z. B. Ca, Ba, Cs, Mg, Al, In, Mg/Ag.

Diese Vorrichtung wird entsprechend (je nach Anwendung) strukturiert, kontaktiert und schließlich auch hermetisch versiegelt, da sich i. d. R. die Lebensdauer derartiger Vorrichtungen bei Anwesenheit von Wasser und/oder Luft drastisch verkürzt. Das Gleiche gilt auch für sogenannte invertierte Strukturen, bei denen das Licht aus der Kathode ausgekoppelt wird. Bei diesen invertierten OLEDs besteht die Anode z. B. aus Al/Ni/NiOx oder Al/Pt/PtOx oder anderen Metall/Metalloxid-Kombinationen, die ein HOMO (höchstes besetztes Molekülorbital) mit einer Energie von größer 5 eV besitzen. Die Kathode besteht dabei aus den gleichen Materialien, die in Punkt 8 und 9 beschrieben sind, mit dem Unterschied, daß das Metall, wie z. B. Ca, Ba, Mg, Al, In, usw., sehr dünn und damit transparent ist. Die Schichtdicke liegt unter 50 nm, besser unter 30 nm, noch besser unter 10 nm. Auf diese transparente Kathode kann noch ein weiteres transparentes Material aufgebracht werden, z. B. ITO (Indium-Zinn-Oxid), IZO (Indium-Zink-Oxid) usw..

Seit längerem ist die Verwendung von Lochblockierschichten (HBL) folgend auf die Emitterschicht aus einem phosphoreszierenden Emitter und einem Matrixmaterial zur Steigerung der Effizienz und der Lebensdauer in organischen Elektrolumineszenzvorrichtungen bekannt.

Wie aus dem oben beschriebenen Aufbau einer phosphoreszierenden OLED hervorgeht, ist dieser sehr aufwendig, da viele Schichten, die wiederum aus vielen verschiedenen Materialien bestehen, nacheinander aufgebracht werden müssen, was den Herstellungsprozeß von kommerziellen OLEDs sehr kompliziert macht. Diese Strukturen werden zumeist nach dem Kriterium der größten Effizienz optimiert. Dabei kommt häufig BCP als Lochblockiermaterial (HBM) zum Einsatz, was allerdings den großen Nachteil hat, daß es die Lebensdauer der OLEDs stark einschränkt. Ein weiteres Lochblockiermaterial ist Bis-(2-methyl-8-hydroxychinolato)-(4-phenylphenolato)-aluminium(III) (BAlq). Damit konnte die Stabilität und Lebensdauer der Devices verbessert werden, allerdings mit dem Nebeneffekt, dass die Quanteneffizienz der Devices deutlich (ca. 40 %) niedriger ist als mit BCP (T. Watanabe et al., Proc. SPIE 2001, 4105, 175). Kwong et al. (Appl. Phys. Lett. 2002, 81, 162) erzielten damit Lebensdauern von 10000 h bei 100 cd/m² mit Tris(phenylpyridy()iridium(III). Allerdings zeigte dieses Device nur eine Effizienz von 19 cd/A, was weit hinter dem Stand der Technik zurückliegt. Somit ist BAIq insgesamt kein zufriedenstellendes Lochblockiermaterial, da die erreichte Effizienz zu niedrig ist.

Bislang gab es mehrere Ansätze, dieses Problem zu lösen. Dabei werden vor allem neue Klassen von Matrixmaterialien vorgeschlagen, die die Verwendung von HBLs überflüssig machen.
- EP 1308494 beschreibt OLEDs, bei denen die Emissionsschicht (EML) aus einem Matrixmaterial mit elektronenleitenden Eigenschaften dotiert mit einem phosphoreszierenden Emitter besteht. Nachteil der hier beschriebenen OLEDs ist, daß in diesem Aufbau nicht die höchsten Effizienzen erzielt werden. Es wird lediglich die Lebensdauer verbessert, was aber mit einer Einbuße an Effizienz bezahlt wird.
- US 2003/0146443 beschreibt OLEDs, bei denen die Emissionsschicht (EML) aus einem Matrixmaterial mit elektronenleitenden Eigenschaften dotiert mit einem phosphoreszierenden Emitter besteht. Dabei vereinfacht sich der Schichtaufbau, da nur noch eine weitere Lochtransportschicht verwendet wird. Diese OLEDs erreichen jedoch nicht die gleiche Effizienz wie herkömmlich aufgebaute OLEDs, d. h. unter Verwendung einer HBL. Zum Teil beobachtet man auch eine, wenn auch geringe, Emission der verwendeten Matrix. Die Autoren kritisieren am Stand der Technik, daß die Lebensdauer der herkömmlichen OLEDs zu gering ist, da die verwendeten Materialien in der HBL eine zu geringe Stabilität haben. Sie machen jedoch selbst keine Angaben zu den Lebensdauern und Stabilitäten der von ihnen hergestellten Strukturen. Dies legt die Vermutung nahe, daß die dort vorgestellten Strukturen das Problem der geringen Stabilität nicht lösen.
- C. Adachi et al. (Organic Electronics 2001, 2, 37) beschreiben phosphoreszierende OLEDs, in denen die carbazolhaltige Matrix (CBP) nicht vollständig mit dem Triplettemitter dotiert ist und in denen kein Lochblockiermaterial verwendet wird, wodurch sich eine undotierte CBP-Schicht zwischen Emitterschicht und Kathode befindet. Jedoch werden in diesem Fall deutlich schlechtere Effizienzen (im Bereich von mehr als einer Größenordnung) erreicht, als wenn die Matrixschicht vollständig dotiert ist, unanhängig davon, ob eine separate Lochblockierschicht verwendet wird oder nicht. Je größer der undotierte Anteil ist, umso schlechter wird die erzielte Effizienz. Es ergeben sich hier also deutliche Nachteile, wenn die Matrix nur teilweise dotiert ist. Weiterhin zeigt sich, dass sich die Emissionsfarbe des Devices deutlich verschiebt, wenn die Matrix nur teilweise dotiert ist. Während das Device mit der vollständig dotierten Matrix die grüne Emission des Triplett-Emitters zeigt, verschiebt sich die Emissionsfarbe bei Verwendung der teildotierten Matrix zur blauen Emission des Lochtransportmaterials. Es ist also offensichtlich, dass sich Matrixmaterialien auf Carbazolbasis nicht für eine unvollständige Dotierung eignen.

Aus dieser Beschreibung des Stands der Technik ist klar, daß insbesondere für effiziente OLEDs bis dato lochblockierende Materialien (HBM), wie z. B. BCP oder BAlq, benötigt werden, die jedoch zu unbefriedigenden Nebeneffekten führen. Es wurde nun überraschend gefunden, daß OLEDs, die dem erfindungsgemäßen - im folgenden aufgeführten - Designprinzip entsprechen, deutliche Verbesserungen gegenüber diesem Stand der Technik aufweisen. Außerdem wurde gefunden, daß mit diesem Designprinzip nicht notwendigerweise eine separate Elektronentransportschicht verwendet werden muß, wodurch sich der Aufbau der OLED wesentlich vereinfacht. Weiterhin werden bei diesem Aufbau deutlich höhere Leistungseffizienzen erreicht.

Gegenstand der Erfindung ist deshalb eine organische Elektrolumineszenzvorrichtung gemäß Anspruch 1.

In den Verbindungen der Formeln (1) bis (4) steht "=" für eine Doppelbindung.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nicht-aromatische Einheit (< 10 % der von H verschiedenen Atome, bevorzugt < 5 % der von H verschiedenen Atome), wie beispielsweise sp³-hybridisierter C, O, N, etc., unterbrochen sein können. So sollen also beispielsweise auch Systeme wie 9,9'-Spirobifluoren, 9,9-Diarylfluoren, Triarylamin, Diphenylether, etc. als aromatische Systeme verstanden werden.

Matrixmaterialien aus den Klassen der Ketone und Imine sind beispielsweise beschrieben in der Patentanmeldung DE 10317556.3; Matrixmaterialien aus den Klassen der Phosphinoxide, der Phosphinsulfide, der Phosphinselenide, der Phosphazene, der Sulfone und der Sulfoxide sind beispielsweise beschrieben in der Patentanmeldung DE 10330761.3. Bevorzugt sind Ketone, Phosphinoxide und Sulfoxide, also Materialien, für die gilt Y = C, P, S und X = O; besonders bevorzugt sind Ketone, also Materialien, für die gilt Y = C und X = O.

Dabei sind explizit auch Materialien möglich und geeignet, die mehr als eine Gruppe Y=X enthalten.

Als besonders geeignete Matrixmaterialien haben sich Verbindungen erwiesen, die nicht planar aufgebaut sind. An der Struktureinheit der Form Y=X können entsprechende Substituenten für eine Abweichung der Gesamtstruktur von der Planarität sorgen. Dies ist insbesondere dann der Fall, wenn mindestens einer der Substituenten R wenigstens ein sp³-hybridisiertes Kohlenstoff-, Silicium-, Germanium- und/oder Stickstoffatom enthält, welches dadurch näherungsweise tetraedrische oder im Fall von Stickstoff pyramidale Bindungsgeometrie aufweist. Um eine deutliche Abweichung von der Planarität zu erreichen, ist es bevorzugt, wenn wenigstens eines der sp³-hybridisierten Atome ein sekundäres, tertiäres oder quartäres Atom ist, besonders bevorzugt ein tertiäres oder quartäres Atom, im Fall von Kohlenstoff, Silicium oder Germanium ganz besonders bevorzugt quartäres Atom ist. Unter einem sekundären, tertiären oder quartären Atom wird ein Atom mit zwei, drei bzw. vier Substituenten ungleich Wasserstoff verstanden.

Erfindungsgemäß sind Verbindungen, die in mindestens einem der Reste R ein 9,9'-Spirobifluorenderivat, bevorzugt verknüpft über die 2- und/oder 2,7- und/oder 2,2'-und/oder 2,2',7- und/oder 2,2',7,7'-Position, ein 9,9-disubstituiertes Fluorenderivat, bevorzugt verknüpft über die 2- und/oder 2,7-Position, ein 6,6- und/oder 12,12-di- oder tetrasubstituiertes Indenofluorenderivat, ein Triptycenderivat, bevorzugt verknüpft über die 9- und/oder 10-Position, ein Dihydrophenanthrenderivat, bevorzugt verknüpft über die 2-und/oder 2,7-Position, ein Hexaarylbenzolderivat, bevorzugt verknüpft über die *p*-Position am/an den Aromaten, oder ein Tetraarylmethanderivat, bevorzugt verknüpft über die *p-*Position am/an den Aromaten, enthalten.

Bevorzugt sind Verbindungen, die in mindestens einem der Reste R ein 9,9'-Spirobifluorenderivat enthalten.

Weiterhin ist die erfindungsgemäße organische Elektrolumineszenzvorrichtung dadurch gekennzeichnet, daß die Glastemperatur T_{g} des Matrixmaterials größer als 100 °C, bevorzugt größer als 120 °C, ganz besonders bevorzugt größer als 140 °C ist.

Es kann bevorzugt sein, wenn die organische Elektrolumineszenzvorrichtung außer den oben genannten Schichten noch eine oder mehrere Lochinjektions- (HIL) und/oder Lochtransportschichten (HTL) enthält. Außerdem kann es bevorzugt sein, wenn die organische Elektrolumineszenzvorrichtung außer den oben genannten Schichten noch eine oder mehrere Elektronentransport- (ETL) und/oder Elektroneninjektionsschichten (EIL) enthält. Es können prinzipiell auch separate Lochblockierschichten (HBL) verwendet werden, jedoch ist deren Verwendung im erfindungsgemäßen Device-Aufbau nicht notwendig und daher auch nicht bevorzugt.

Bevorzugt ist eine organische Elektrolumineszenzvorrichtung **dadurch gekennzeichnet, daß** eine oder mehrere Dotierungszonen in der Matrixschicht und eine oder mehrere undotierte Zonen in der Matrixschicht vorhanden sind und eine undotierte Zone in der Matrixschicht an die Elektronentransportschicht ETL (bzw. EIL bzw. Kathode) angrenzt und eine Dotierungszone in der Matrixschicht an die Lochtransportschicht HTL (bzw. HIL bzw. Anode) angrenzt.

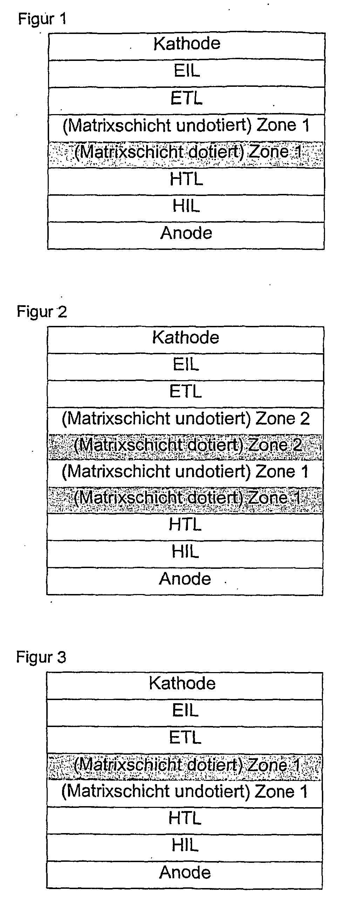

Eine mögliche Ausführungsform der Erfindung ist in Figur 1 beschrieben. Die Matrixschicht besteht hier aus einem dotierten und undotierten Bereich, wobei der dotierte Bereich an die HTL angrenzt und der undotierte an die ETL angrenzt. Auch wenn dies aus der Beschreibung hervorgeht, sei darauf hingewiesen, daß das Matrixmaterial in der dotierten und undotierten Matrixschicht (beide Zone 1) identisch ist.

Es sei explizit darauf verwiesen, daß in Figur 1 (ebenso wie in allen folgenden Abbildungen) die Verwendung einer separaten EIL, ETL, HTL und/oder HIL nicht zwingend notwendig ist und daß die Verwendung dieser Schichten nur mögliche Ausführungsformen der Erfindung sind. Die Abbildung dieser Schichten in Figur 1 bis 8 ist also nur beispielhaft zu sehen und soll die allgemeine Ausführung dieser Erfindung nicht einschränken. Ebenso sind entsprechende Vorrichtungen ohne diese Schichten erfindungsgemäß.

Eine weitere mögliche Ausführungsform der Erfindung ist in Figur 2 beschrieben. Die Matrixschicht besteht aus zwei dotierten und zwei undotierten Bereichen, wobei ein dotierter Bereich an die HTL angrenzt und ein undotierter an die ETL angrenzt. Auch wenn dies aus der Beschreibung hervorgeht, sei nochmals explizit darauf hingewiesen, daß das Matrixmaterial in jeder einzelnen Zone identisch ist, bevorzugt ist es in allen Zonen identisch.

Die Matrixschicht kann auch aus drei oder mehr dotierten und undotierten Bereichen bestehen. Zwei oder drei sich abwechselnde dotierte und undotierte Bereiche sind besonders für weiß emittierende OLEDs geeignet.

Weiterhin bevorzugt ist eine organische Elektrolumineszenzvorrichtung **dadurch gekennzeichnet, daß** eine oder mehrere Dotierungszonen in der Matrixschicht und eine oder mehrere undotierte Zonen in der Matrixschicht vorhanden sind und eine undotierte Zone in der Matrixschicht an die Lochtransportschicht HTL (bzw. HIL bzw. Anode) angrenzt und eine Dotierungszone in der Matrixschicht an die Elektronentransportschicht ETL (bzw. EIL bzw. Kathode) angrenzt.

Eine weitere mögliche Ausführungsform der Erfindung ist in Figur 3 beschrieben. Die Matrixschicht besteht aus einem dotierten und undotierten Bereich, wobei der dotierte Bereich an die ETL angrenzt und der undotierte Bereich an die HTL angrenzt. Auch wenn dies aus der Beschreibung hervorgeht, sei nochmals explizit darauf hingewiesen, daß das Matrixmaterial in der dotierten und undotierten Matrixschicht (beide Zone 1) identisch ist.

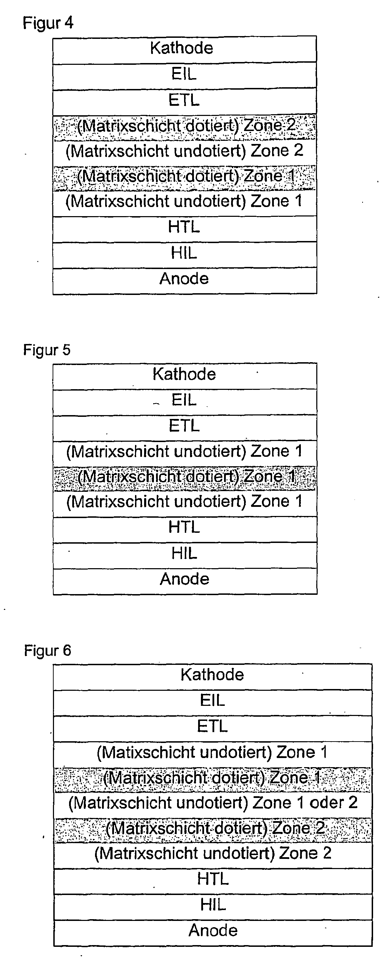

Eine weitere mögliche Ausführungsform der Erfindung ist in Figur 4 beschrieben. Die Matrixschicht besteht aus zwei dotierten und undotierten Bereichen, wobei ein dotierter Bereich an die ETL angrenzt und ein undotierter an die HTL angrenzt. Auch wenn dies aus der Beschreibung hervorgeht, sei nochmals explizit darauf hingewiesen, daß das Matrixmaterial in jeder einzelnen Zone identisch ist, bevorzugt ist es in allen Zonen identisch.

Bevorzugt ist eine organische Elektrolumineszenzvorrichtung **dadurch gekennzeichnet, daß** eine oder mehrere Dotierungszonen in der Matrixschicht und eine oder mehrere undotierte Zonen in der Matrixschicht vorhanden sind und eine undotierte Zone in der Matrixschicht an die Elektronentransportschicht ETL (bzw. EIL bzw. Kathode) und eine undotierte Zone an die Lochtransportschicht HTL (bzw. HIL bzw. Anode) angrenzt.

Eine weitere mögliche Ausführungsform der Erfindung ist in Figur 5 beschrieben. Die Matrixschicht besteht aus einem dotierten und zwei undotierten Bereichen, wobei die beiden undotierten Bereiche an die HTL und an die ETL angrenzen und der dotierte Bereich dazwischen liegt. Auch wenn dies aus der Beschreibung hervorgeht, sei nochmals explizit darauf hingewiesen, daß das Matrixmaterial in der dotierten und undotierten Matrixschicht (beide Zone 1) identisch ist.

Eine weitere mögliche Ausführungsform der Erfindung ist in Figur 6 beschrieben. Die Matrixschicht besteht aus zwei dotierten und drei undotierten Bereichen, wobei undotierte Bereiche an die HTL und an die ETL angrenzen und dazwischen abwechselnd dotierte und undotierte Bereiche liegen. Auch wenn dies aus der Beschreibung hervorgeht, sei nochmals explizit darauf hingewiesen, daß das Matrixmaterial in jeder einzelnen Zone identisch ist, bevorzugt ist es in allen Zonen identisch. In gleicher Weise kann die Matrixschicht auch aus drei oder mehr dotierten und vier oder mehr undotierten Bereichen bestehen.

Bevorzugt ist eine organische Elektrolumineszenzvorrichtung **dadurch gekennzeichnet, daß** eine oder mehrere Dotierungszonen in der Matrixschicht und eine oder mehrere undotierte Zonen in der Matrixschicht vorhanden sind und eine Dotierungszone in der Matrixschicht an die Elektronentransportschicht ETL (bzw. EIL bzw. Kathode) und eine Dotierungszone an die Lochtransportschicht HTL (bzw. HIL bzw. Anode) angrenzt.

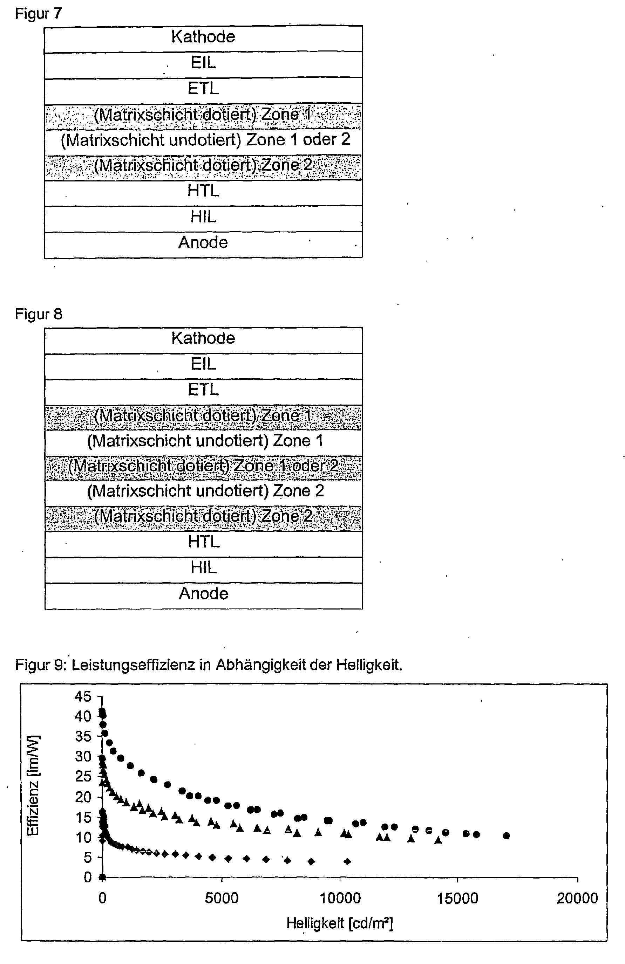

Eine weitere mögliche Ausführungsform der Erfindung ist in Figur 7 beschrieben. Die Matrixschicht besteht aus einem undotierten und zwei dotierten Bereichen, wobei die beiden dotierten Bereiche an die HTL und an die ETL angrenzen und der undotierte Bereich dazwischen liegt. Auch wenn dies aus der Beschreibung hervorgeht, sei nochmals explizit darauf hingewiesen, daß das Matrixmaterial in jeder einzelnen Zone identisch ist, bevorzugt ist es in allen Zonen identisch.

Eine weitere mögliche Ausführungsform der Erfindung ist in Figur 8 beschrieben. Die Matrixschicht besteht aus zwei undotierten und drei dotierten Bereichen, wobei dotierte Bereiche an die HTL und an die ETL angrenzen und dazwischen abwechselnd dotierte und undotierte Bereiche liegen. Auch wenn dies aus der Beschreibung hervorgeht, sei nochmals explizit darauf hingewiesen, daß das Matrixmaterial in jeder einzelnen Zone identisch ist, bevorzugt ist es in allen Zonen identisch. In gleicher Weise kann die Matrixschicht auch aus vier oder mehr dotierten und drei oder mehr undotierten Bereichen bestehen.

In verschiedenen Zonen können prinzipiell verschiedene Matrixmaterialien eingesetzt werden, mit der Maßgabe, daß mindestens ein Matrixmaterial ausgewählt ist aus den Formeln (1) bis (4). Es müssen jedoch nicht alle Matrixmaterialien aus den Formeln (1) bis (4) ausgewählt sein. So können in einem Teil der Zonen beispielsweise auch andere Matrixmaterialien vorhanden sein. Aus Gründen der Praktikabilität und der Wirtschaftlichkeit hat es sich jedoch als vorteilhaft erwiesen, wenn in mehreren Zonen die gleichen Matrixmaterialien verwendet werden; besonders bevorzugt werden die gleichen Matrixmaterialien in mehreren angrenzenden Zonen verwendet; ganz besonders bevorzugt werden für alle Zonen die gleichen Matrixmaterialien verwendet.

In einer weiteren bevorzugten Ausführung wird einer jeden Zone eine andere Emissionsfarbe, welch durch den Dotanden bestimmt wird, zugeordnet.

In einer bevorzugten Ausführungsform der Erfindung enthält die erfindungsgemäße Elektrolumineszenzvorrichtung keine separate Lochblockierschicht (HBL).

In einer weiteren bevorzugten Ausführungsform der Erfindung enthält die erfindungsgemäße Elektrolumineszenzvorrichtung keine separate Lochblockierschicht (HBL) und keine separate Elektronentransportschicht (ETL), das heißt, der dotierte bzw. undotierte Teil der Matrixschicht grenzt direkt an die Kathode bzw. an die Elektroneninjektionsschicht.

Die erfindungsgemäße Elektrolumineszenzvorrichtung enthält auch nicht notwendigerweise eine Lochinjektions- und/oder Lochtransportschicht (HIL bzw. HTL), d. h. der dotierte bzw. undotierte Teil der Matrixschicht kann auch direkt an die Lochinjektionsschicht bzw. direkt an die Anode grenzen.

Bevorzugt ist eine organische Elektrolumineszenzvorrichtung **dadurch gekennzeichnet, daß** die Schichtdicke der Dotierungszone zwischen 98 % und 40 %, bevorzugt zwischen 90 % und 60 % der Matrixschichtdicke beträgt.

Bevorzugt ist eine organische Elektrolumineszenzvorrichtung **dadurch gekennzeichnet, daß** die Schichtdicke der Matrixschicht eine Dicke von 1 bis 150 nm aufweist, bevorzugt von 5 bis 100 nm.

Bevorzugt ist eine organische Elektrolumineszenzvorrichtung **dadurch gekennzeichnet, daß** das Matrixmaterial im sichtbaren Spektralbereich zwischen 380 nm und 750 nm bei einer Filmdicke von 30 nm eine Extinktion kleiner 0.2, bevorzugt kleiner 0.1, besonders bevorzugt kleiner 0.05, aufweist.

Weiterhin bevorzugt ist eine organische Elektrolumineszenzvorrichtung **dadurch gekennzeichnet, daß** als phosphoreszierender Emitter eine Verbindung enthalten ist, die mindestens ein Atom der Ordnungszahl größer 36 und kleiner 84 aufweist.

Besonders bevorzugt ist eine organische Elektrolumineszenzvorrichtung **dadurch gekennzeichnet, daß** der phosphoreszierende Emitter mindestens ein Element der Ordnungszahl größer 56 und kleiner 80, ganz besonders bevorzugt Molybdän, Wolfram, Rhenium, Ruthenium, Osmium, Rhodium, Iridium, Palladium, Platin, Silber, Gold oder Europium, insbesondere Iridium oder Platin, beispielsweise gemäß den Patentanmeldungen WO 98/01011, US 02/0034656, US 03/0022019, WO 00/70655, WO 01/41512, WO 02/02714, WO 02/15645, EP 1191613, EP 1191612, EP 1191614, WO 03/040257 und WO 03/084972 enthält.

Weiterhin bevorzugt ist eine organische Elektrolumineszenzvorrichtung **dadurch gekennzeichnet, daß** eine oder mehrere Schichten mit einem Sublimationsverfahren beschichtet werden. Dabei werden die niedermolekularen Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung **dadurch gekennzeichnet, daß** eine oder mehrere Schichten mit dem OVPD (Organic Vapour Phase Deposition) Verfahren oder mit Hilfe einer Trägergassublimation beschichtet werden. Dabei werden die niedermolekularen Materialien bei einem Druck zwischen 10⁻⁵ mbar und 1 bar aufgebracht.

Weiterhin bevorzugt ist eine organische Elektrolumineszenzvorrichtung **dadurch gekennzeichnet, daß** eine oder mehrere Schichten mit einem beliebigen Druckverfahren, wie z. B. Flexodruck oder Offsetdruck, besonders bevorzugt LITI (Light Induced Thermal Imaging, Thermotransferdruck) und Ink-Jet Druck (Tintenstrahl-Druck), beschichtet werden.

Die oben beschriebenen emittierenden Vorrichtungen weisen nun folgende überraschende Vorteile gegenüber dem Stand der Technik auf:
1. Die Effizienz entsprechender Vorrichtungen wird höher im Vergleich zu Systemen, die nicht dem erfindungsgemäßen Design folgen, d. h. eine oder mehrere separate HBLs enthalten. Dies ist insbesondere überraschend, da ein vergleichbarer Aufbau bei Devices, die carbazolhaltige Matrizes verwenden, zu einem starken Rückgang der Effizienz führt (vgl. Adachi et al., Organic Electronics 2001, 2, 37).
2. Die Stabilität und die Lebensdauer entsprechender Vorrichtungen wird höher im Vergleich zu Systemen, die nicht dem erfindungsgemäßen Design folgen, d. h. die eine oder mehrere separate HBLs enthalten.
3. Die Betriebsspannungen werden wesentlich verringert; dadurch erhöht sich die Leistungseffizienz. Dies gilt insbesondere, wenn keine separate Elektronentransportschicht verwendet wird, d. h. wenn die Matrixschicht direkt an die Kathode bzw. die Elektroneninjektionsschicht grenzt.
4. Die Schichtaufbau ist einfacher, weil mindestens eine organische Schicht weniger verwendet wird. Ein besonders deutlicher Vorteil ist gegeben, wenn die Matrixschicht direkt an die Kathode bzw. die Elektroneninjektionsschicht grenzt, weil dann weder eine separate Lochblockierschicht, noch eine separate Elektronentransportschicht verwendet werden müssen. Ebenso ist der Schichtaufbau besonders einfach, wenn keine separate Lochtransportschicht und/oder keine separate Lochinjektionsschicht verwendet werden.
5. Der Produktionsaufwand wird geringer, weil mindestens eine organische Schicht weniger verwendet wird. Dies ist ein erheblicher Vorteil im Produktionsprozeß, da bei der herkömmlichen Herstellungsweise für jede organische Schicht eine separate Aufdampfanlage verwendet wird, wodurch mindestens eine derartige Anlage somit eingespart wird bzw. komplett entfällt.
6. Das Emissionsspektrum ist identisch zum Emissionsspektrum, das mit einer dotierten Matrix und einem Lochblockiermaterial erhalten wird. Dies ist essentiell für die Anwendung und ist insbesondere ein überraschendes Ergebnis, da eine teilweise dotierte Matrix basierend auf carbazolhaltige Verbindungen zu extremen Änderungen des Emissionsspektrums führt, so daß die Emission schließlich nicht mehr aus dem Triplettemitter, sondern aus dem Lochtransportmaterial kommt (vgl. Adachi et al., Organic Electronic 2001, 2, 37); ein Device mit einer solchen Farbverschiebung ist für die Anwendung unbrauchbar.

Details zu den hier gemachten Angaben finden sich in den unten beschriebenen Beispielen.

Im vorliegenden Anmeldetext und auch in den weiteren folgenden Beispielen wird nur auf organische Leuchtdioden und die entsprechenden Displays abgezielt. Trotz dieser Beschränkung der Beschreibung ist es für den Fachmann ohne weiteres erfinderisches Zutun möglich, das entsprechende erfindungsgemäße Design auch für andere, verwandte Vorrichtungen, z. B. für organische Solarzellen (O-SCs), organische Feldeffekttransistoren (O-FETs) oder auch organische Laserdioden (O-Laser), um nur einige weitere Anwendungen zu nennen, zu verwenden.

### Beispiele:

### Herstellung und Charakterisierung von organischen Elektrolumineszenzvorrichtungen, die dem erfindungsgemäßen Aufbau entsprechen.

Die Herstellung von OLEDs erfolgte nach dem im folgenden skizzierten allgemeinen Verfahren. Dieses mußte im Einzelfall auf die jeweiligen Gegebenheiten (z. B. Schichtdickenvariation, um optimale Effizienz bzw. Farbe zu erreichen) angepaßt werden. Für die Herstellung der erfindungsgemäßen Vorrichtungen wurde die separate Lochblockierschicht weggelassen, in manchen der Beispiele außerdem die Elektronentransportschicht, und die Emitterschicht wurde entsprechend der obigen Beschreibung gestaltet.

Erfindungsgemäße Elektrolumineszenzvorrichtungen können, wie beispielsweise in der Patentanmeldung DE10330761.3 beschrieben wurde, dargestellt werden.

In den folgenden Beispielen werden die Ergebnisse verschiedener OLEDs vorgestellt. Der grundlegende Aufbau, wie die verwendeten Materialien und Schichtdicken, außer der EML und der HBL, waren zur besseren Vergleichbarkeit identisch.

Analog dem o: g. allgemeinen Verfahren wurden emittierende OLEDs mit folgendem Aufbau erzeugt:

| | |
|---|---|
| PEDOT (HIL) | 60 nm (aus Wasser aufgeschleudert; PEDOT bezogen von H. C. Starck; Poly-[3,4-ethylendioxy-2,5-thiophen]) |
| NaphDATA (HTM) | 20 nm (aufgedampft; NaphDATA bezogen von SynTec; 4,4',4"-Tris(N-1-naphthyl-N-phenyl-amino)-triphenylamin |
| S-TAD (HTM) | 20 nm (aufgedampft; S-TAD hergestellt nach WO 99/12888; |
| | 2,2',7,7'-Tetrakis(diphenylamino)-spirobifluoren) |
| Emitter-Schicht: | genauer Aufbau siehe Beispiele in Tabelle |
| BCP (HBL) | ggf. 10 nm; siehe Vergleichsbeispiele in Tabelle |
| AlQ₃ (ETL) | nicht in allen Fällen verwendet (siehe Tabelle); wenn vorhanden: 10 nm |
| | (aufgedampft: AlQ₃ bezogen von SynTec; |
| | Tris(hydroxychinolinato)aluminium(III)) |
| Ba-Al (Kathode) | 3 nm Ba, darauf 150 nm Al. |

Diese noch nicht optimierten OLEDs wurden standardmäßig charakterisiert; hierfür wurden die Elektrolumineszenzspektren, die Effizienz (gemessen in cd/A) und die Leistungseffizienz (gemessen in Im/W) in Abhängigkeit von der Helligkeit, berechnet aus Strom-Spannungs-Helligkeit-Kennlinien (IUL-Kennlinien), und die Lebensdauer bestimmt. Unter Lebensdauer versteht man die Zeit, nach der die Anfangshelligkeit der OLED bei einer konstanten Stromdichte von 10 mA/cm² auf die Hälfte gesunken ist.

In Tabelle 1 sind die Ergebnisse verschiedener Beispiele zusammengefaßt. Die Zusammensetzung der gesamten EMLs und HBLs inklusive der entsprechenden Schichtdicken ist aufgeführt. In den Beispielen 1 und 2 wurde eine separate Elektronentransportschicht verwendet. Die Beispiele 3 bis 5 beschreiben Vorrichtungen sowohl mit wie auch ohne separate Elektronentransportschicht. Die dotierten phosphoreszierenden EMLs enthalten als Matrixmaterial **M1** die Verbindung Bis(9,9'-spirobifluoren-2-yl)keton, als Matrixmaterial **M2** die Verbindung Bis(9,9'-spirobifluoren-2-yl)sulfoxid, als Matrixmaterial **M3** die Verbindung Bis(9,9'-spirobifluoren-2-yl)phenylphosphinoxid und als Matrixmaterial **M4** die Verbindung 2,7-Bis(2-Spiro-9,9'-bifluorenyl-carbonyl)-spiro-9,9'-bifluoren. Die Synthesen dieser Verbindungen sind in den nicht offen gelegten Anmeldungen DE 10317556.3 und DE 10330761.3 beschrieben. In den aufgeführten Beispielen, die dem erfindungsgemäßen Aufbau entsprechen, besteht die EML aus einer 30 nm dicken dotierten Zone und einer darauf folgenden 10 nm dicken undotierten Zone.

Die in der Tabelle 1 verwendeten Abkürzungen entsprechen den folgenden Verbindungen:

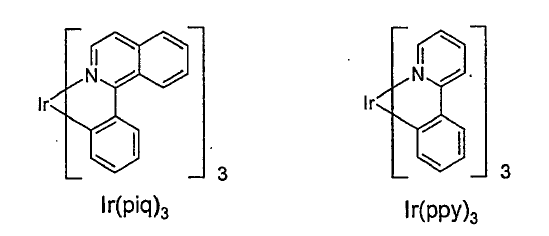

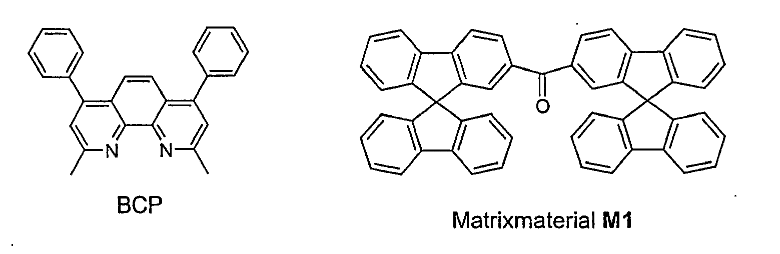

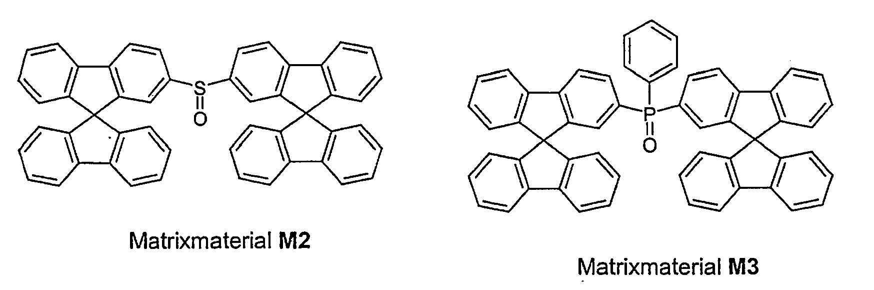

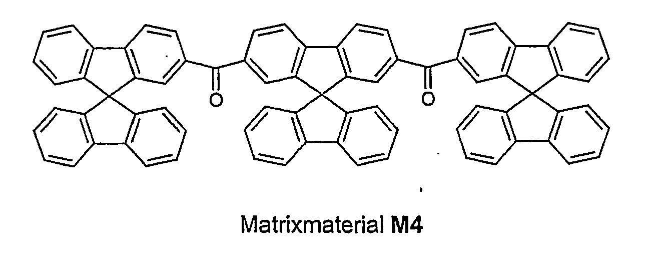

**Tabelle 1:**

| Experiment | EML | EML | HBL | ETL | Max. Effizienz (cd/A) | Leistungseffizienz (Im/W) | Max. Spannung (V) bei 100 cd/m² | CIE (x, y) | Lebensdauer (h) bei 10 mA/cm² |
|---|---|---|---|---|---|---|---|---|---|
| | | | | | | | | | 12000 |
| Beispiel 1a | **M1**:20% Ir(piq)₃ | **M1** | - | AlQ₃ | 6.6 | 3.7 | 5.4 | 0.69/0.31 | (extropoliert nach |
| | (30 nm) | (10 nm) | | (10 nm) | | | | | 6000 h) |
| Beispiel 1b | **M1**:20% Ir(piq)₃ | - | BCP | AlQ₃ | 4.6 | 2.2 | 6.5 | 0.68/0.32 | 256 |
| (Vergleich) | (30 nm) | | | (10 nm) | | | | | |
| Beispiel 2a | **M2**:20% Ir(ppy)₃ | **M2** | - | AlQ₃ | 16.2 | 7.9 | 6.1 | 0.33/0.61 | 356 |
| | (30 nm) | (10 nm) | | (10 nm) | | | | | |
| Beispiel 2b | **M2**:20% Ir(ppy)₃ | - | BCP | AlQ₃ | 13.4 | 6.5 | 6.3 | 0.33/0.61 | 234 |
| (Vergleich) | (30 nm) | | | (10 nm) | | | | | |
| Beispiel 3a | **M1**:20% Ir(ppy)₃ | **M1** | - | AlQ₃ | 34.1 | 32.1 | 3.4 | 0.36/0.60 | 368 |
| | (30 nm | (10nm) | | (10 nm) | | | | | |
| Beispiel 3b | **M1**:20% Ir(ppy)₃ | **M1** | - | - | 34.5 | 41.4 | 3.1 | 0.36/0.60 | 423 |
| | (30 nm) | (20 nm) | | | | | | | |
| Beispiel 3c | **M1**:20% Ir(ppy)₃ | - | BCP | AlQ₃ | 31.8 | 15.6 | 4.8 | 0.36/0.60 | 357 |
| (Vergleich) | (30 nm) | | | (10 nm) | | | | | |
| Beispiel 5a | **M3**:20% Ir(ppy)₃ | **M3** | - | AlQ₃ | 32.9 | 30.1 | 3.5 | 0.36/0.60 | 336 |
| | (30 nm) | (10 nm) | | (10 nm) | | | | | |
| Beispiel 5b | **M3**:20% Ir(ppy)₃ | **M3** | - | - | 35.3 | 33.9 | 3.2 | 0.36/0.60 | 142 |
| | (30 nm) | (10 nm) | | | | | | | |
| Beispiel 5c | **M3**:20% Ir(ppy)₃ | - | BCP | AlQ₃ | 31.7 | 12.2 | 7.7 | 0.36/0.60 | 132 |
| (Vergleich) | (30 nm) | | | (10 nm) | | | | | |
| Beispiel 6a | **M4**:20% Ir(piq)₃ | **M4** | | AlQ₃ | 6.3 | 4.5 | 5.5 | 0.69/0.31 | 17000 |
| | (30 nm) | (10 nm) | - | (10 nm) | | | | | (extrapoliert nach 5000 h) |
| Beispiel 6b | **M4**:20% Ir(piq)₃ | **M4** | - | - | 6.4 | 6.2 | 3.9 | 0.69/0.31 | 8400 |
| | (30 nm) | (10 nm) | | | | | | | (extrapoliert nach 5000 h) |
| Beispiel 6c | **M4**:20% Ir(piq)₃ | - | BCP | AlQ₃ | 6.1 | 4.2 | 5.8 | 0.69/0.31 | 3700 |
| (Vergleich) | (30 nm) | | | (10 nm) | | | | | |

| | | | | | | | | | |
|---|---|---|---|---|---|---|---|---|---|
| Legende: **M1** = Bis(9,9'-spirobifluoren-2-yl)keton **M2** = Bis(9,9'-spirobifluoren-2-yl)sulfoxid **M3** = Bis(9,9'-spirobifluoren-2-yl)phenylphosphinoxid **M4** = 2,7-Bis(2-Spiro-9,9'-bifluorenyl-carbonyl)-spiro-9,9'-bifluoren | | | | | | | | | |

In Figur 9 ist exemplarisch die Leistungseffizienz (ImIW) bei Dotierung von Ir(ppy)₃ in **M1** einmal dem neuen Designprinzip folgend (gemäß Experiment 3a, ▲) und einmal dem Vergleichsstandard entsprechend (gemäß Experiment 3c, ◆) dargestellt. Die Leistungseffizienz aus Experiment 3a ist etwa doppelt so hoch. Die Leistungseffizienz (gemäß Experiment 3b, ●) ohne HBL und ohne ETL ist nochmals etwa 30 bis 50 % höher.

Dieselbe Beobachtung, wie oben für Beispiel 3 dargestellt, wird auch für die anderen Beispiele gemacht, wie der Tabelle 1 zu entnehmen ist.

Zusammenfassend kann gesagt werden, daß OLEDs, gefertigt nach dem neuen Designprinzip, eine höhere Effizienz bei niedrigeren Spannungen und längere Lebensdauern aufweisen, wie man leicht aus Tabelle 1 entnehmen kann. Dies gilt für alle beschriebenen Matrixmaterialien und Matrixmaterialklassen, wie hier in den Beispielen für Ketone, Phosphinoxide und Sulfoxide belegt. Insbesondere wenn keine separate Elektronentransportschicht verwendet wird, die Matrixschicht also direkt an die Kathode oder die Elektroneninjektionsschicht grenzt, ist die Spannung besonders niedrig und damit die Leistungseffizienz besonders hoch.

## Patentansprüche

1. Organische Elektrolumineszenzvorrichtung, enthaltend eine Anode, eine Kathode und mindestens eine Matrixschicht, enthaltend als Matrixmaterial mindestens eine Verbindung gemäß Formel (1) bis (4) (Schema 1), 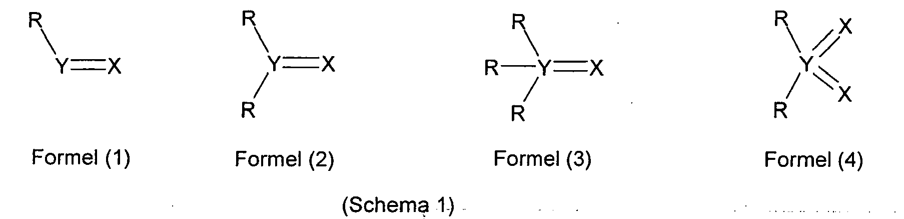 wobei die verwendeten Symbole folgende Bedeutung haben:
Y ist gleich C in Formel (2) und ist gleich P in Formel (1) und (3) und ist gleich S in Formel (1), (2) und (4);
X ist bei jedem Auftreten O;
R ist bei jedem Auftreten gleich oder verschieden, ein aromatisches oder heteroaromatisches Ringsystem mit 1 bis 40 C-Atomen, das durch einen oder mehrere Reste R¹, CN, B(R²)₂ oder Si(R²)₃ substituiert sein kann, wobei mehrere Substituenten R miteinander ein mono- oder polycyclisches, aliphatisches oder aromatisches Ringsystem bilden können;
R¹ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -R²C=CR²-, -C=C-, Si(R²)₂, Ge(R²)₂, Sn(R²)₂, -NR²-, -O-, -S-, -CO-O- oder -O-CO-O- ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R² substituiert sein kann, oder OH oder N(R²)₂;
R² ist bei jedem Auftreten gleich oder verschieden H oder ein aliphatischer oder aromatischer Kohlenwasserstoffrest mit 1 bis 20 C-Atomen;
wobei mindestens einer der Reste R ein 9,9'-Spirobifluorenderivat, ein 9,9-disubstituiertes Fluorenderivat, ein 6,6- und/oder 12,12-di- oder tetrasubstituiertes Indenofluorenderivat, ein Triptycenderivat, ein Dihydrophenanthren-Derivat, ein Hexaarylbenzolderivat oder ein Tetraarylmethanderivat enthält,
wobei die Glastemperatur T_{g} des Matrixmaterials größer als 100 °C ist, und mit der Maßgabe, daß die Molmasse des Matrixmaterials größer 150 g/mol ist, und
wobei die Matrixschicht mit mindestens einem phosphoreszierenden Emitter dotiert ist, **dadurch gekennzeichnet, dass** sich die Dotierungszone des Emitters in der Matrix senkrecht zur Schicht nur über einen Teil der Matrixschicht erstreckt.

2. Organische Elektrolumineszenzvorrichtung gemäß Anspruch 1, **dadurch gekennzeichnet, dass** mindestens einer der Reste R mindestens ein sekundäres, tertiäres oder quartäres Atom enthält.

3. Organische Elektrolumineszenzvorrichtung gemäß Anspruch 2, **dadurch gekennzeichnet, dass** mindestens einer der Reste R ein quartäres Atom enthält.

4. Organische Elektrolumineszenzvorrichtung gemäß Anspruch 1, **dadurch gekennzeichnet, dass** mindestens einer der Reste R ein 9,9'-Spirobifluorenderivat enthält.

5. Organische Elektrolumineszenzvorrichtung gemäß einem oder mehreren der Ansprüche 1 bis 4, **dadurch gekennzeichnet, dass** die organische Elektrolumineszenzvorrichtung eine oder mehrere Lochinjektions- (HIL) und/oder eine oder mehrere Lochtransportschichten (HTL) enthält.

6. Organische Elektrolumineszenzvorrichtung gemäß einem oder mehreren der Ansprüche 1 bis 5, **dadurch gekennzeichnet, dass** die organische Elektrolumineszenzvorrichtung eine oder mehrere Elektronentransport- (ETL) und/oder eine oder mehrere Elektroneninjektionsschichten (EIL) enthält.

7. Organische Elektrolumineszenzvorrichtung gemäß einem oder mehreren der Ansprüche 1 bis 6, **dadurch gekennzeichnet, dass** eine oder mehrere Dotierungszonen in der Matrixschicht und eine oder mehrere undotierte Zonen in der Matrixschicht vorhanden sind und eine undotierte Zone in der Matrixschicht an die Elektronentransportschicht ETL (bzw. EIL bzw. Kathode) angrenzt und eine Dotierungszone in der Matrixschicht an die Lochtransportschicht HTL (bzw. HIL bzw. Anode) angrenzt.

8. Organische Elektrolumineszenzvorrichtung gemäß einem oder mehreren der Ansprüche 1 bis 6, **dadurch gekennzeichnet, dass** eine oder mehrere Dotierungszonen in der Matrixschicht und eine oder mehrere undotierte Zonen in der Matrixschicht vorhanden sind und eine undotierte Zone in der Matrixschicht an die Lochtransportschicht HTL (bzw. HIL bzw. Anode) angrenzt und eine Dotierungszone in der Matrixschicht an die Elektronentransportschicht ETL (bzw. EIL bzw. Kathode) angrenzt.

9. Organische Elektrolumineszenzvorrichtung gemäß einem oder mehreren der Ansprüche 1 bis 6, **dadurch gekennzeichnet, dass** eine oder mehrere Dotierungszonen in der Matrixschicht und eine oder mehrere undotierte Zonen in der Matrixschicht vorhanden sind und eine undotierte Zone in der Matrixschicht an die Elektronentransportschicht ETL (bzw. EIL bzw. Kathode) und eine undotierte Zone an die Lochtransportschicht HTL (bzw. HIL bzw. Anode) angrenzt.

10. Organische Elektrolumineszenzvorrichtung gemäß einem oder mehreren der Ansprüche 1 bis 6, **dadurch gekennzeichnet, dass** eine oder mehrere Dotierungszonen in der Matrixschicht und eine oder mehrere undotierte Zonen in der Matrixschicht vorhanden sind und eine Dotierungszone in der Matrixschicht an die Elektronentransportschicht ETL (bzw. EIL bzw. Kathode) und eine Dotierungszone an die Lochtransportschicht HTL (bzw. HIL bzw. Anode) angrenzt.

11. Organische Elektrolumineszenzvorrichtung gemäß einem oder mehreren der Ansprüche 1 bis 10, **dadurch gekennzeichnet, dass** die dotierte oder undotierte Matrixschicht direkt an die Kathode bzw. die Elektroneninjektionsschicht (EIL) grenzt.

12. Organische Elektrolumineszenzvorrichtung gemäß einem oder mehreren der Ansprüche 1 bis 11, **dadurch gekennzeichnet, dass** die dotierte oder undotierte Matrixschicht direkt an die Lochinjektionsschicht (HIL) oder direkt an die Anode grenzt.

13. Organische Elektrolumineszenzvorrichtung gemäß einem oder mehreren der Ansprüche 1 bis 12, **dadurch gekennzeichnet, dass** die Schichtdicke der Dotierungszone zwischen 98 % bis 40 % der Matrixschichtdicke beträgt.

14. Organische Elektrolumineszenzvorrichtung gemäß einem oder mehreren der Ansprüche 1 bis 13, **dadurch gekennzeichnet, dass** die Matrixschicht eine Schichtdicke von 1 bis 150 nm aufweist.

15. Organische Elektrolumineszenzvorrichtung gemäß einem oder mehreren der Ansprüche 1 bis 14, **dadurch gekennzeichnet, dass** als phosphoreszierender Emitter eine Verbindung enthalten ist, die mindestens ein Atom der Ordnungszahl größer 36 und kleiner 84 aufweist.

16. Organische Elektrolumineszenzvorrichtung gemäß Anspruch 15, **dadurch gekennzeichnet, dass** der phosphoreszierende Emitter Molybdän, Wolfram, Rhenium, Ruthenium, Osmium, Rhodium, Iridium, Palladium, Platin, Silber, Gold oder Europium enthält.

17. Verfahren zur Herstellung einer organischen Elektrolumineszenzvorrichtung gemäß einem oder mehreren der Ansprüche 1 bis 16, **dadurch gekennzeichnet, dass** eine oder mehrere Schichten mit einem Sublimationsverfahren hergestellt werden.

18. Verfahren zur Herstellung einer organischen Elektrolumineszenzvorrichtung gemäß einem oder mehreren der Ansprüche 1 bis 16, **dadurch gekennzeichnet, dass** eine oder mehrere Schichten mit dem OVPD (Organic Vapour Phase Deposition) Verfahren aufgebracht werden.

19. Verfahren zur Herstellung einer organischen Elektrolumineszenzvorrichtung gemäß einem oder mehreren der Ansprüche 1 bis 16, **dadurch gekennzeichnet, dass** eine oder mehrere Schichten mit einem Druck-Verfahren beschichtet werden.

20. Verfahren gemäß Anspruch 19, **dadurch gekennzeichnet, dass** eine oder mehrere Schichten mit dem LITI (Light Induced Thermal Imaging) Verfahren beschichtet werden.

21. Verfahren gemäß Anspruch 19, **dadurch gekennzeichnet, dass** eine oder mehrere Schichten mit dem Ink-Jet (Tintenstrahldruck) Verfahren beschichtet werden.

## Claims

1. Organic electroluminescent device comprising an anode, a cathode and at least one matrix layer comprising, as matrix material, at least one compound of the formulae (1) to (4) (Scheme 1), 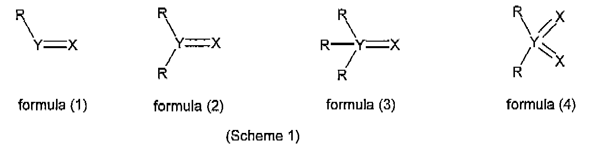 where the symbols used have the following meaning:
Y is equal to C in formula (2) and is equal to P in formulae (1) and (3) and is equal to S in formulae (1), (2) and (4);
X is on each occurrence O;
R is on each occurrence, identically or differently, an aromatic or heteroaromatic ring system having 1 to 40 C atoms, which may be substituted by one or more radicals R¹, CN, B(R²)₂ or Si(R²)₃, where a plurality of substituents R may form a mono- or polycyclic, aliphatic or aromatic ring system with one another;
R¹ is on each occurrence, identically or differently, a straight-chain, branched or cyclic alkyl or alkoxy chain having 1 to 22 C atoms, in which, in addition, one or more non- adjacent C atoms may be replaced by -R²C=CR²-, -C≡C-, Si(R²)₂, Ge(R²)₂, Sn(R²)₂, -NR²-, -O-, -S-, -CO-O- or -O-CO-O- and in which one or more H atoms may be replaced by fluorine, or is an aryl, heteroaryl or aryloxy group having 1 to 40 C atoms, which, in addition, may be substituted by one or more radicals R², or is OH or N(R²)₂-,
R² is on each occurrence, identically or differently, H or an aliphatic or aromatic hydrocarbon radical having 1 to 20 C atoms;
where at least one of the radicals R contains a 9,9'-spirobifluorene derivative, a 9,9-disubstituted fluorene derivative, a 6,6- and/or 12,12-di- or tetrasubstituted indeno-fluorene derivative, a triptycene derivative, a dihydrophenanthrene derivative, a hexaarylbenzene derivative or a tetraarylmethane derivative,
where the glass transition temperature T_{g} of the matrix material is greater than 100°C, and with the proviso that the molecular weight of the matrix material is greater than 150 g/mol, and
where the matrix layer is doped with at least one phosphorescent emitter, **characterised in that** the doping zone of the emitter in the matrix extends only over part of the matrix layer perpendicular to the layer.

2. Organic electroluminescent device according to Claim 1, **characterised in that** at least one of the radicals R contains at least one secondary, tertiary or quaternary atom.

3. Organic electroluminescent device according to Claim 2, **characterised in that** at least one of the radicals R contains a quaternary atom.

4. Organic electroluminescent device according to Claim 1, **characterised in that** at least one of the radicals R contains a 9,9'-spirobifluorene derivative.

5. Organic electroluminescent device according to one or more of Claims 1 to 4, **characterised in that** the organic electroluminescent device comprises one or more hole-injection layers (HILs) and/or one or more hole-transport layers (HTLs).

6. Organic electroluminescent device according to one or more of Claims 1 to 5, **characterised in that** the organic electroluminescent device comprises one or more electron-transport layers (ETLs) and/or one or more electron-injection layers (EILs).

7. Organic electroluminescent device according to one or more of Claims 1 to 6, **characterised in that** one or more doping zones are present in the matrix layer and one or more undoped zones are present in the matrix layer, and an undoped zone in the matrix layer is adjacent to the electron-transport layer ETL (or EIL or cathode) and a doping zone in the matrix layer is adjacent to the hole-transport layer HTL (or HIL or anode).

8. Organic electroluminescent device according to one or more of Claims 1 to 6, **characterised in that** one or more doping zones are present in the matrix layer and one or more undoped zones are present in the matrix layer, and an undoped zone in the matrix layer is adjacent to the hole-transport layer HTL (or HIL or anode) and a doping zone in the matrix layer is adjacent to the electron-transport layer ETL (or EIL or cathode).

9. Organic electroluminescent device according to one or more of Claims 1 to 6, **characterised in that** one or more doping zones are present in the matrix layer and one or more undoped zones are present in the matrix layer, and an undoped zone in the matrix layer is adjacent to the electron-transport layer ETL (or EIL or cathode) and an undoped zone is adjacent to the hole-transport layer HTL (or HIL or anode).

10. Organic electroluminescent device according to one or more of Claims 1 to 6, **characterised in that** one or more doping zones are present in the matrix layer and one or more undoped zones are present in the matrix layer, and a doping zone in the matrix layer is adjacent to the electron-transport layer ETL (or EIL or cathode) and a doping zone is adjacent to the hole-transport layer HTL (or HIL or anode).

11. Organic electroluminescent device according to one or more of Claims 1 to 10, **characterised in that** the doped or undoped matrix layer is directly adjacent to the cathode or the electron-injection layer (EIL).

12. Organic electroluminescent device according to one or more of Claims 1 to 11, **characterised in that** the doped or undoped matrix layer is directly adjacent to the hole-injection layer (HIL) or directly adjacent to the anode.

13. Organic electroluminescent device according to one or more of Claims 1 to 12, **characterised in that** the layer thickness of the doping zone is between 98% and 40% of the thickness of the matrix layer.

14. Organic electroluminescent device according to one or more of Claims 1 to 13, **characterised in that** the matrix layer has a layer thickness of 1 to 150 nm.

15. Organic electroluminescent device according to one or more of Claims 1 to 14, **characterised in that** the phosphorescent emitter present is a compound which contains at least one atom having an atomic number of greater than 36 and less than 84.

16. Organic electroluminescent device according to Claim 15, **characterised in that** the phosphorescent emitter comprises molybdenum, tungsten, rhenium, ruthenium, osmium, rhodium, iridium, palladium, platinum, silver, gold or europium.

17. Process for the production of an organic electroluminescent device according to one or more of Claims 1 to 16, **characterised in that** one or more layers are produced using a sublimation method.

18. Process for the production of an organic electroluminescent device according to one or more of Claims 1 to 16, **characterised in that** one or more layers are applied using the OVPD (organic vapour phase deposition) method.

19. Process for the production of an organic electroluminescent device according to one or more of Claims 1 to 16, **characterised in that** one or more layers are applied using a printing process.

20. Process according to Claim 19, **characterised in that** one or more layers are applied using the LITI (light induced thermal imaging) process.

21. Process according to Claim 19, **characterised in that** one or more layers are applied using the ink-jet printing process.

## Revendications

1. Dispositif électroluminescent organique comprenant une anode, une cathode et au moins une couche de matrice comprenant, en tant que matériau de matrice, au moins un composé des formules (1) à (4) (Schéma 1), 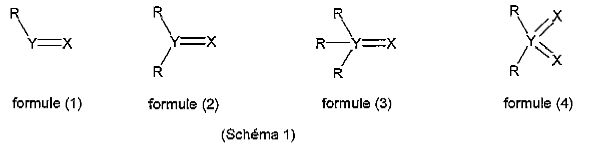 dans lesquelles les symboles utilisés ont les significations suivantes:
Y est égal à C dans la formule (2) et est égal à P dans les formules (1) et (3) et est égal à S dans les formules (1), (2) et (4);
X est dans chaque occurrence O;
R est dans chaque occurrence, de façon identique ou différente, un système de cycle aromatique ou hétéroaromatique ayant 1 à 40 atomes de C, qui peut être substitué par un ou plusieurs radicaux R¹, CN, B(R²)₂ ou Si(R²)₃, où une pluralité de substi- tuants R peuvent former avec un autre un système de cycle aliphatique ou aroma- tique, mono- ou polycyclique;
R¹ est dans chaque occurrence, de façon identique ou différente, une chaîne alkyle ou alcoxy en chaîne droite, ramifiée ou cyclique ayant 1 à 22 atomes de C, dans la- quelle, en addition, un ou plusieurs atomes de C non adjacents peuvent être rem- placés par -R²C=CR²-, -C≡C-, Si(R²)₂, Ge(R²)₂, Sn(R²)₂, -NR²-, -O-, -S-, -CO-O- ou -O-CO-O- et dans laquelle un ou plusieurs atomes de H peuvent être remplacés par fluor, ou est un groupe aryle, hétéroaryle ou aryloxy ayant 1 à 40 atomes de C, qui, en addition, peut être substitué par un ou plusieurs radicaux R², ou est OH ou N(R²)₂-;
R² est dans chaque occurrence, de façon identique ou différente, H ou un radical hydrocarbure aliphatique ou aromatique ayant 1 à 20 atomes de C;
où au moins un des radicaux R contient un dérivé 9,9'-spirobifluorène, un dérivé fluorène 9,9-disubstitué, un dérivé indénofluorène 6,6- et/ou 12,12-di- ou tétrasubstitué, un dérivé triptycène, un dérivé dihydrophènanthrène, un dérivé hexaarylbenzène ou un dérivé tétraarylméthane.
où la température de transition vitreuse T_{g} du matériau de matrice est supérieure à 100°C, et avec la réserve que le poids moléculaire du matériau de matrice est supérieur à 150 g/mol, et
où la couche de matrice est dopées avec au moins un émetteur phosphorescent,
**caractérisé en ce que** la zone de dopage de l'émetteur dans la matrice s'étend seulement sur une partie de la couche de matrice perpendiculaire à la couche.

2. Dispositif électroluminescent organique selon la revendication 1, **caractérisé en ce qu'**au moins un des radicaux R contient au moins un atome secondaire, tertiaire ou quaternaire.

3. Dispositif électroluminescent organique selon la revendication 2, **caractérisé en ce qu'**au moins un des radicaux R contient un atome quaternaire.

4. Dispositif électroluminescent organique selon la revendication 1, **caractérisé en ce qu'**au moins un des radicaux R contient un dérivé 9,9'-spirobifluorèrie.

5. Dispositif électroluminescent organique selon une ou plusieurs des revendications 1 à 4, **caractérisé en ce que** le dispositif électroluminescent organique comprend une ou plusieurs couches d'injection de trous (HILs) et/ou une ou plusieurs couches de transport de trous (HTLs).

6. Dispositif électroluminescent organique selon une ou plusieurs des revendications 1 à 5, **caractérisé en ce que** le dispositif électroluminescent organique comprend une ou plusieurs couches de transport d'électrons (ETLs) et/ou une ou plusieurs couches d'injection d'électrons (EILs).

7. Dispositif électroluminescent organique selon une ou plusieurs des revendications 1 à 6, **caractérisé en ce qu'**une ou plusieurs zones de dopage sont présentes dans la couche de matrice et une ou plusieurs zones non dopées sont présentes dans la couche de matrice, et une zone non dopée dans la couche de matrice est adjacente à la couche de transport d'électrons ETL (ou EIL ou cathode) et une zone de dopage dans la couche de matrice est adjacente à la couche de transport de trous HTL (ou HIL ou anode).

8. Dispositif électroluminescent organique selon une ou plusieurs des revendications 1 à 6, **caractérisé en ce qu'**une ou plusieurs zones de dopage sont présentes dans la couche de matrice et une ou plusieurs zones non dopées sont présentes dans la couche de matrice, et une zone non dopée dans la couche de matrice est adjacente à la couche de transport de trous HTL (ou HIL ou anode) et une zone de dopage dans la couche de matrice est adjacente à la couche de transport d'électrons ETL (ou EIL ou cathode).

9. Dispositif électroluminescent organique selon une ou plusieurs des revendications 1 à 6, **caractérisé en ce qu'**une ou plusieurs zones de dopage sont présentes dans la couche de matrice et une ou plusieurs zones non dopées sont présentes dans la couche de matrice, et une zone non dopée dans la couche de matrice est adjacente à la couche de transport d'électrons ETL (ou EIL ou cathode) et une zone non dopée est adjacente à la couche de transport de trous HTL (ou HIL ou anode).

10. Dispositif électroluminescent organique selon une ou plusieurs des revendications 1 à 6, **caractérisé en ce qu'**une ou plusieurs zones de dopage sont présentes dans la couche de matrice et une ou plusieurs zones non dopées sont présentes dans la couche de matrice, et une zone de dopage dans la couche de matrice est adjacente à la couche de transport d'électrons ETL (ou EIL ou cathode) et une zone de dopage est adjacente à la couche de transport de trous HTL (ou HIL ou anode).

11. Dispositif électroluminescent organique selon une ou plusieurs des revendications 1 à 10, **caractérisé en ce que** la couche de matrice dopée ou non dopée est directement adjacente à la cathode ou la couche d'injection d'électrons (EIL).

12. Dispositif électroluminescent organique selon une ou plusieurs des revendications 1 à 11, **caractérisé en ce que** la couche de matrice dopée ou non dopée est directement adjacente à couche d'injection de trous (HIL) ou directement adjacente à l'anode.

13. Dispositif électroluminescent organique selon une ou plusieurs des revendications 1 à 12, **caractérisé en ce que** l'épaisseur de couche de la zone de dopage est entre 98% et 40% de l'épaisseur de la couche de matrice.

14. Dispositif électroluminescent organique selon une ou plusieurs des revendications 1 à 13, **caractérisé en ce que** la couche de matrice a une épaisseur de couche de 1 à 150 nm.

15. Dispositif électroluminescent organique selon une ou plusieurs des revendications 1 à 14, **caractérisé en ce que** l'émetteur phosphorescent présent est un composé qui contient au moins un atome ayant un numéro atomique supérieur à 36 et inférieur à 84.

16. Dispositif électroluminescent organique selon la revendication 15, **caractérisé en ce que** the l'émetteur phosphorescent comprend du molybdène, tungstène, rhénium, ruthénium, osmium, rhodium, iridium, palladium, platine, argent, or ou europium.

17. Procédé pour la production d'un dispositif électroluminescent organique selon une ou plusieurs des revendications 1 à 16, **caractérisé en ce qu'**une ou plusieurs couches sont produites en utilisant un procédé de sublimation.

18. Procédé pour la production d'un dispositif électroluminescent organique selon une ou plusieurs des revendications 1 à 16, **caractérisé en ce qu'**une ou plusieurs couches sont appliquées en utilisant le procédé OVPD (dépôt organique en phase vapeur).

19. Procédé pour la production d'un dispositif électroluminescent organique selon une ou plusieurs des revendications 1 à 16, **caractérisé en ce qu'**une ou plusieurs couches sont appliquées en utilisant un processus d'impression.

20. Procédé selon la revendication 19, **caractérisé en ce qu'**une ou plusieurs couches sont appliquées en utilisant le processus LITI (formation d'image thermique induite par lumière).

21. Procédé selon la revendication 19, **caractérisé en ce qu'**une ou plusieurs couches sont appliquées en utilisant le processus d'impression par jets d'encre.
